# EUROPEAN PATENT APPLICATION

(11) **EP 4 709 115 A1**
(43) Date of publication of application: **11.03.2026**
(21) Application number: 25176123.5
(22) Date of filing: 13.05.2025
(51) Int. Cl.: H10K 59/131, H10K 59/122, H10K 59/124

(54) **DISPLAY APPARATUS AND ELECTRONIC APPARATUS INCLUDING THE SAME**

(30) Priority: 04.09.2024 KR 20240119933
(71) Applicant: Samsung Display Co., Ltd., Yongin-si, Gyeonggi-do 17113 (KR)
(72) Inventor: BANG, Kiho, 17113 Yongin-si (KR); HWANG, Inho, 17113 Yongin-si (KR); YANG, Deokwon, 17113 Yongin-si (KR); YEO, Inhyuck, 17113 Yongin-si (KR); LEE, Seongryong, 17113 Yongin-si (KR); CHOI, Wonsuk, 17113 Yongin-si (KR)
(74) Representative: Walaski, Jan Filip

(57) **Abstract**

A display apparatus includes a substrate having a bending area positioned between a first area and a second area. The substrate is bendable in the bending area along a bending axis. A conductive layer extends from the first area to the second area through the bending area, and arranged on the substrate. A first organic insulating layer is arranged on the conductive layer and has a first thickness. A second organic insulating layer is arranged on the first organic insulating layer and has a second thickness. A third organic insulating layer is arranged on the second organic insulating layer and has a third thickness. A sum of the first to third thicknesses is in a range of about 2 to about 30 times a thickness of the conductive layer.

## Description

### CROSS-REFERENCE TO RELATED APPLICATION

This application claims priority to Korean Patent Application No. 10-2024-0119933, filed on 4 September 2024 in the Korean Intellectual Property Office.

### 1. TECHNICAL FIELD

The disclosure relates to a display apparatus.

### 2. DISCUSSION OF RELATED ART

Among display apparatuses, an organic light-emitting display apparatus is attracting attention as a next-generation display device due to features including a wide viewing angle, excellent contrast, and a fast response speed.

Typically, an organic light-emitting display apparatus may include thin-film transistors and organic light-emitting diodes as display elements on a substrate. The organic light-emitting diodes operate by self-emitting light. The organic light-emitting display apparatus may be utilized as a display unit of a large variety of electronic apparatuses, including a relatively small-sized product such as a portable phone, a relatively medium-sized product, such as a tablet, and a relatively large-sized product, such as a television.

### SUMMARY

One or more embodiments provide a display apparatus capable of reducing strain in a bending area.

Additional aspects will be set forth in part in the description which follows and, in part, will be apparent from the description, or may be learned by practice of described embodiments of the present disclosure.

According to an embodiment of the present disclosure, a display apparatus includes a substrate having a bending area positioned between a first area and a second area. The substrate is bendable in the bending area along a bending axis. A conductive layer extends from the first area to the second area through the bending area, and arranged on the substrate. A first organic insulating layer is arranged on the conductive layer and has a first thickness. A second organic insulating layer is arranged on the first organic insulating layer and has a second thickness. A third organic insulating layer is arranged on the second organic insulating layer and has a third thickness. A sum of the first to third thicknesses is in a range of about 2 to about 30 times a thickness of the conductive layer.

In an embodiment, a thickness of one of the first organic insulating layer to the third organic insulating layer may be greater than a thickness of another organic insulating layer of the first to third organic insulating layers.

In an embodiment, the third thickness of the third organic insulating layer may be less than or equal to a sum of the first thickness of the first organic insulating layer and the second thickness of the second organic insulating layer.

In an embodiment, the third thickness of the third organic insulating layer may be twice the first thickness of the first organic insulating layer or the second thickness of the second organic insulating layer.

In an embodiment, the second organic insulating layer may include a material that is different from the first organic insulating layer and the third organic insulating layer.

In an embodiment, the second thickness of the second organic insulating layer may be equal to the first thickness of the first organic insulating layer, and the third thickness of the third organic insulating layer may be twice the first thickness of the first organic insulating layer.

In an embodiment, the display apparatus may further include a fourth organic insulating layer arranged on the third organic insulating layer and having a fourth thickness, and a sum of the first to fourth thicknesses may be in a range of about 2 to about 30 times the thickness of the conductive layer.

In an embodiment, the third organic insulating layer may include a material different from materials of the first organic insulating layer and the second organic insulating layer.

In an embodiment, the third thickness of the third organic insulating layer may be less than or equal to the second thickness of the second organic insulating layer.

In an embodiment, the display apparatus may further include a pixel defining layer arranged on the first area, and defining an emission area through an opening, and a spacer arranged on the pixel defining layer, and the third organic insulating layer may include a same material as a material of the pixel defining layer.

In an embodiment, the pixel defining layer may include a light-shielding material.

According to an embodiment of the present disclosure, a display apparatus includes a substrate having a bending area positioned between a first area and a second area. The substrate is bendable in the bending area along a bending axis. A plurality of wires extends from the first area to the second area through the bending area, and arranged on the substrate. A first organic insulating layer is arranged on the plurality of wires and has a first thickness. A second organic insulating layer is arranged on the first organic insulating layer and has a second thickness. A third organic insulating layer is arranged on the second organic insulating layer and has a third thickness. At least one of the first organic insulating layer to the third organic insulating layer includes a plurality of insulating patterns arranged to be spaced apart from each other.

In an embodiment, the plurality of insulating patterns may overlap the plurality of wires.

In an embodiment, in an area where the plurality of insulating patterns overlap the plurality of wires, a thickness of at least one of the first organic insulating layer to the third organic insulating layer may be greater than a thickness of another organic insulating layer of the first to third organic insulating layers.

In an embodiment, in the area where the plurality of insulating patterns overlap the plurality of wires, the third thickness of the third organic insulating layer may be twice the first thickness of the first organic insulating layer or the second thickness of the second organic insulating layer.

In an embodiment, the display apparatus may further include a fourth organic insulating layer arranged on the third organic insulating layer and having a fourth thickness, and the third organic insulating layer may include a material different from materials of the first organic insulating layer and the second organic insulating layer.

In an embodiment, the third thickness of the third organic insulating layer may be less than or equal to the second thickness of the second organic insulating layer.

In an embodiment, the display apparatus may further include a pixel defining layer arranged on the first area, and defining an emission area through an opening, and a spacer arranged on the pixel defining layer, and the third organic insulating layer may include the same material as a material of the pixel defining layer.

In an embodiment, the pixel defining layer may include a light-shielding material.

In an embodiment, a thickness of one of the first organic insulating layer to the third organic insulating layer may be greater than a thickness of another organic insulating layer.

According to an embodiment of the present disclosure, an electronic apparatus comprises a processor. A memory has stored application programs for execution by the processor. A display apparatus comprises a substrate having a bending area positioned between a first area and a second area, the substrate is bendable in the bending area along a bending axis. A conductive layer extends from the first area to the second area through the bending area, and arranged on the substrate. A first organic insulating layer is arranged on the conductive layer and has a first thickness. A second organic insulating layer is arranged on the first organic insulating layer and has a second thickness. A third organic insulating layer is arranged on the second organic insulating layer and has a third thickness. A sum of the first to third thicknesses is in a range of about 2 to about 30 times a thickness of the conductive layer. A user interface is configured to sense user input via touch or cursor select of an icon presented on the display apparatus. The processor is caused to execute one or more of the stored application programs upon receipt of the user input.

According to an embodiment of the present disclosure, an electronic apparatus includes a processor. A memory has stored application programs for execution by the processor. A display apparatus comprises a substrate having a bending area positioned between a first area and a second area. The substrate is bendable in the bending area along a bending axis. A plurality of wires extends from the first area to the second area through the bending area, and arranged on the substrate. A first organic insulating layer is arranged on the plurality of wires and having a first thickness. A second organic insulating layer is arranged on the first organic insulating layer and has a second thickness. A third organic insulating layer is arranged on the second organic insulating layer and has a third thickness. At least one of the first organic insulating layer to the third organic insulating layer comprises a plurality of insulating patterns arranged to be spaced apart from each other. A user interface is configured to sense user input via touch or cursor select of an icon presented on the display apparatus. The processor is caused to execute one or more of the stored application programs upon receipt of the user input.

According to an embodiment of the present disclosure, a display apparatus includes a substrate having a bending area positioned between a first area and a second area. The substrate is bendable in the bending area along a bending axis. A conductive layer is arranged on the substrate and extends in the first area, the bending area, and the second area. A plurality of organic insulating layers is consecutively disposed directly on the conductive layer. A total sum of the plurality of organic insulating layers is greater than or equal to about 6.0 µm. The display apparatus does not include a bending protection layer disposed in the bending area.

In an embodiment, the plurality of organic insulating layers includes a first organic insulating layer having a first thickness, a second organic insulating layer having a second thickness and a third organic insulating layer having a third thickness.

In an embodiment, an inorganic insulating layer is disposed in the first and second areas. At least a portion of the inorganic insulating layer is removed from the bending area and filled with a lower organic layer. The conductive layer directly contacts an upper surface of the lower organic layer.

In an embodiment, the plurality of organic insulating layers further includes a fourth organic insulating layer having a fourth thickness.

In an embodiment, the first thickness of the first organic insulating layer, the second thickness of the second organic insulating layer, the third thickness of the third organic insulating layer and the fourth thickness of the fourth organic insulating layer have a ratio of 3:3:2:4.

In an embodiment, a touch insulating layer is disposed on an input sensing layer. The touch insulating layer does not extend to the bending area to form the bending protection layer.

### BRIEF DESCRIPTION OF THE DRAWINGS

The above and other aspects, features, and advantages of certain non-limiting embodiments of the present disclosure will be more apparent from the following description taken in conjunction with the accompanying drawings, in which:
FIG. 1 is a plan view of a portion of a display apparatus;
FIG. 2 is a schematic cross-sectional view of a portion of a structure after the display apparatus of FIG. 1 is bent;
FIG. 3 is an equivalent circuit diagram of a pixel that may be included in a display apparatus;
FIG. 4 is a schematic cross-sectional view of a cross-section taken along line I-I' of the display apparatus of FIG. 1;
FIG. 5 is a diagram merely illustrating a part III of FIG. 4;
FIG. 6 is a diagram illustrating the part III of FIG. 4;
FIG. 7 is a diagram illustrating the part III of FIG. 4;
FIGS. 8 and 9 are schematic cross-sectional views taken along line II-II' of FIG. 2; and
FIG. 10 is a cross-sectional view for comparing a display apparatus with a display apparatus according to a comparative example.
FIG. 11 is a diagram of an electronic device.

### DETAILED DESCRIPTION OF EMBODIMENTS

Reference will now be made in detail to non-limiting embodiments, examples of which are illustrated in the accompanying drawings, wherein like reference numerals refer to like elements throughout. In this regard, embodiments of the present disclosure may have different forms and should not be construed as being limited to the descriptions set forth herein. Accordingly, non-limiting embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

As the present disclosure allows for various changes and numerous embodiments, non-limiting embodiments will be illustrated in the drawings and described in detail in the written description. Effects and features of embodiments of the present disclosure and methods of achieving the same will be apparent with reference to non-limiting embodiments and drawings described below in detail. The present disclosure may, however, be embodied in many different forms and should not be construed as being limited to described embodiments set forth herein.

In the following embodiments, while such terms as "first," "second," etc., may be used to describe various elements, such elements must not be limited to the above terms.

In the following embodiments, an expression used in the singular encompasses the expression of the plural, unless it has a clearly different meaning in the context.

In the following embodiments, it is to be understood that the terms such as "including" and "having" are intended to indicate the existence of the features, or elements disclosed in the present disclosure, and are not intended to preclude the possibility that one or more other features or elements may exist or may be added.

It will be understood that when a unit, region, or element is referred to as being formed on another unit, region, or element, it can be directly or indirectly formed on the other unit, region, or element. That is, for example, intervening units, regions, or elements may be present. When a unit, region, or element is referred to as being formed directly on another unit, region, or element, no intervening elements may be present.

In the following embodiments, terms such as connect or couple do not necessarily mean a direct and/or fixed connection or coupling of two members, unless the context clearly indicates otherwise, and do not exclude the case where another member is interposed between the two members.

Sizes of elements in the drawings may be exaggerated for convenience of explanation. In other words, since sizes and thicknesses of components in the drawings are arbitrarily illustrated for convenience of explanation, the following embodiments are not limited thereto.

The present disclosure will now be described more fully with reference to the accompanying drawings, in which preferred embodiments of the present disclosure are shown. Like reference numerals in the drawings denote like elements, and thus their description will not be repeated.

The present disclosure relates to a display apparatus that includes an organic film laminated structure in a bending area and excludes a bending protection layer in the bending area. The sum of the thicknesses of the organic film laminated structure may be preset to provide a reduced product thickness. For example, the sum of the thicknesses of the organic film laminated structure may be greater than or equal to about 6.0 µm.

The organic film laminated structure may adjust the position of the stress neutral plane (NP) without including a bending protection layer. The organic film laminated structure reduces the strain of the bending area even when applying a tight bending structure and may reduce the non-display area by the minimum margin distance.

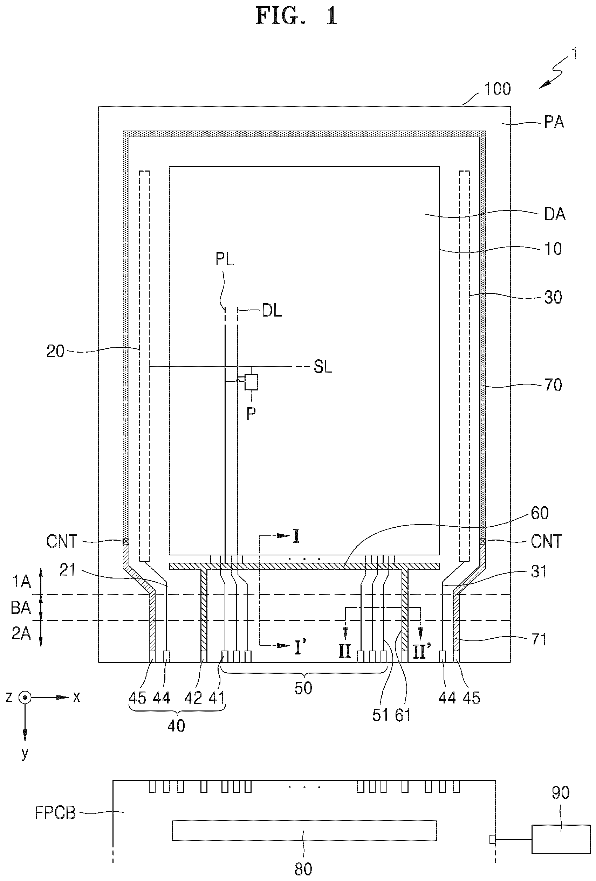

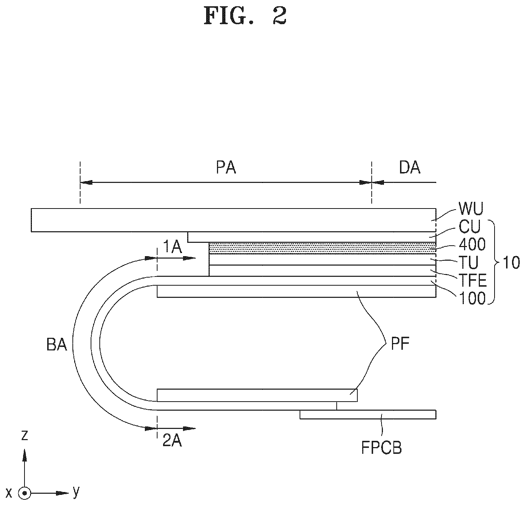

FIG. 1 is a plan view of a portion of a display apparatus, and FIG. 2 is a schematic cross-sectional view of a portion of a structure after the display apparatus of FIG. 1 is bent.

Referring to FIGS. 1 and 2, a substrate 100 of a display apparatus 1 may have a bending area BA located between a first area 1A and a second area 2A. With respect to one direction (e.g., a +x direction) and another direction (e.g., a +y direction) crossing the one direction, the bending area BA may be located between the first area 1A and the second area 2A in another direction (e.g., the +y direction). Additionally, the substrate 100 may be bent in the bending area BA (e.g., be bendable to have a bent orientation) with respect to a bending axis extending in the one direction (e.g., the +x direction) in the bending area BA.

The substrate 100 may include various materials having a flexible or bendable characteristic. For example, the substrate 100 may include polymer resin such as polyethersulphone (PES), polyacrylate (PAR), polyetherimide (PEI), polyethylene napthalate (PEN), polyethylene terephthalate (PET), polyphenylene sulfide (PPS), polyarylate (PAR), polyimide (PI), polycarbonate (PC), or cellulose acetate propionate (CAP).

A display area DA may be included in the first area 1A. The first area 1A may include a display area DA and a portion of a peripheral area PA surrounding the display area DA (e.g., in a plan view). The peripheral area PA may include a portion of the first area 1A excluding the display area DA, the bending area BA, and the second area 2A.

Referring to FIG. 1, the display apparatus 1 may include a display unit 10 disposed on the substrate 100. The display unit 10 may include pixels P connected to a scan line SL extending in the y direction and a data line DL extending in the x direction crossing the y direction. The display unit 10 may provide one or more moving and/or still images through light emitted from the pixels P and the pixels P may define the display area DA.

The pixels P may each emit, for example, red light, green light, blue light, or white light. The pixels P may each include a display element, and the display element may include an organic light-emitting diode. The "pixel P" as used herein may may be defined as a pixel that emits light of any one color among red color, green color, blue color, or white color, as described above.

The peripheral area PA may be provided outside the display area DA. For example, the peripheral area PA may surround the display area DA (e.g., in a plan view). The peripheral area PA may be an area in which the pixels P are not disposed, and thus may correspond to a non-display area where an image is not displayed. The bending area BA may be defined as a portion of the peripheral area PA. Therefore, the bending area BA may be a non-display area in which an image is not displayed.

Drive circuits, such as first and second scan drive circuits 20 and 30, a pad unit 40, driving power supply lines 60, and common power supply lines 70, may be arranged in the peripheral area PA.

The first and second scan drive circuits 20 and 30 may be arranged on the peripheral area PA of the substrate 100, and may generate and transmit scan signals to the pixels P through corresponding scan lines SL. For example, the first scan drive circuit 20 may be arranged on the left side of the display unit 10 (e.g., in the -x direction), and the second scan drive circuit 30 may be arranged on the right side of the display unit 10 (e.g., in the +x direction), but they are not necessarily limited thereto. For example, only one scan drive circuit may be provided.

The pad unit 40 may be arranged on one end portion of the substrate 100 and may include a plurality of pads 41, 42, 44, and 45. The pad unit 40 may be exposed without being covered with an insulating layer, to be electrically connected to a flexible printed circuit board FPCB. The pad unit 40 may be arranged on one side of the substrate 100 where the first and second scan drive circuits 20 and 30 are not located. For example, the pad unit 40 may be arranged on a lower end portion of the substrate 100 (e.g., in the y direction).

The flexible printed circuit board FPCB may electrically connect a controller 90 and the pad unit 40. A signal or power transmitted from the controller 90 may move through wires 21, 31, 51, 61, and 71 connected to the pad unit 40.

The controller 90 may receive a vertical synchronization signal, a horizontal synchronization signal, and a clock signal, and generate control signals for controlling the driving of the first and second scan drive circuits 20 and 30. The generated signals may be transmitted to the first and second scan drive circuits 20 and 30, respectively, through the pads 44 and the wires 21 and 31, which are connected to the flexible printed circuit board FPCB. The scan signals of the first and second scan drive circuits 20 and 30 may be applied to the respective pixels P through the scan lines SL. The controller 90 may supply driving power ELVDD and common power ELVSS to the driving power supply line 60 and the common power supply line 70, respectively, through the pads 42 and 45 and wires 61 and 71 connected to the flexible printed circuit board FPCB. The driving power ELVDD supplied to the corresponding pixel P through a driving voltage line PL, and the common power ELVSS may be supplied to a common electrode of the pixel P.

A data drive circuit 80 may be arranged on the flexible printed circuit board FPCB. The data drive circuit 80 may apply a data signal to each pixel P. The data signal of the data drive circuit 80 may be applied to the corresponding pixel P through the wire 51 connected to the pad 41 and the data line DL connected to the wire 51. In FIG. 1, the data drive circuit 80 is shown being arranged on the flexible printed circuit board FPCB, but it is not necessarily limited thereto. For example, the data drive circuit 80 may be arranged on the peripheral area PA of the substrate 100.

The driving power supply line 60 may be arranged on the peripheral area PA. For example, the driving power supply line 60 may be located between the pad unit 40 and one side of the display unit 10 adjacent to the pad unit 40. The driving power ELVDD supplied through the wire 61 connected to the pad 42 may be supplied to the pixels P through the driving voltage lines PL.

The common power supply line 70 may be arranged on the peripheral area PA and may partially surround the display unit 10. For example, the common power supply line 70 may have a loop shape, in which one side of the display unit 10 adjacent to the pad unit 40 is open, and may be connected along the edge of the substrate 100 excluding the pad unit 40.

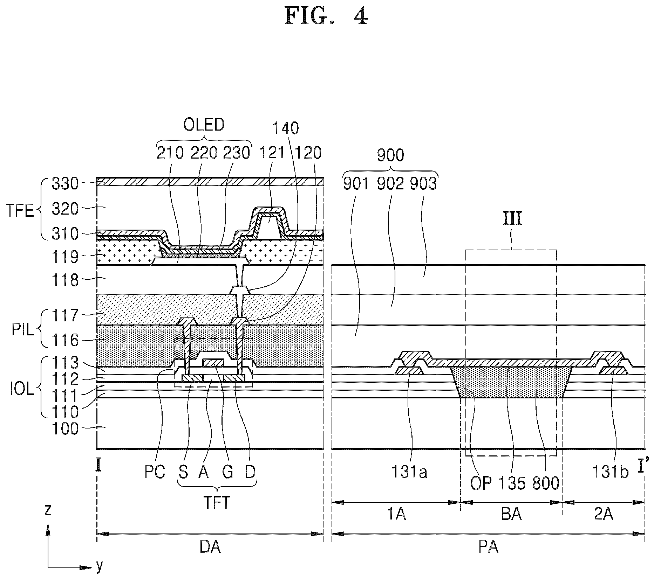

The common power supply line 70 of FIG. 1 may be electrically connected to the wire 71 connected to the pad 45, and supply common power ELSS to a counter electrode 230 (see FIG. 4) (e.g., cathode) of the organic light-emitting diode OLED of the pixel P. In FIG. 1, it is illustrated that the common power supply line 70 has the loop shape, in which one side partially surrounding the display unit 10 is open and partially overlaps the wire 71 connected to the pad 45. The wire 71 connected to the pad 45 and the common power supply line 70 may be connected to each other through a contact hole CNT of an insulating layer, for example, an inorganic insulating layer interposed therebetween. A connection area, such as the contact hole CNT between the wire 71 connected to the pad 45 and the common power supply line 70 may be an area adjacent to one side of the display unit 10 which faces the pad unit 40. However, it is not necessarily limited thereto. For example, the common power supply line 70 may be directly connected to the pad 45 without separately using the wire 71 connected to the pad 45.

The display unit 10 may include a thin-film encapsulation layer TFE, an input sensing layer TU, and an anti-reflection layer CU. In FIG. 2, it is shown that the thin-film encapsulation layer TFE is arranged on the substrate 100, but this is only a schematic illustration for convenience of explanation, and a display layer which includes a driving thin-film transistor Td (see FIG. 4) and an organic light-emitting diode OLED (see FIG. 4) to be described later, may be provided on the substrate 100.

In the display apparatus 1, at least some of the components including the display layer, the thin-film encapsulation layer TFE, the input sensing layer TU, and the anti-reflection layer CU may be formed through a continuous process, or at least some of the components may be coupled through adhesive members. An adhesive member to be described below may include a typical adhesive or glue.

The thin-film encapsulation layer TFE may encapsulate the organic light-emitting diode OLED to suppress the penetration of moisture or oxygen. The thin-film encapsulation layer TFE may be arranged to cover not only the display unit 10 but also circuit parts (e.g., the first and second scan drive circuits 20 and 30 and the common power supply line 70) disposed on the peripheral area PA, and extend to the edge of the substrate 100.

The input sensing layer TU may be arranged on the display layer. The input sensing layer TU may be disposed directly on the display layer. The expression "element B is directly disposed on element A" as used herein means that no separate adhesive layer/adhesive member is disposed between element A and element B. Element B may be formed through a continuous process on a base surface provided by element A after element A is formed. The input sensing layer TU may obtain coordinate information on external input (e.g., touch event).

The anti-reflection layer CU may be arranged on the input sensing layer TU. The anti-reflection layer CU may include a color filter disposed to correspond to an emission area of the corresponding pixel P, and a light-shielding layer disposed to correspond to a non-emission area between the pixels P.

The anti-reflection layer CU may reduce the reflectance of external light incident on an upper side of a cover window WU. The anti-reflection layer CU may include a phase retarder and a polarizer. The phase retarder may be a film type or a liquid crystal-coated type, and may include a λ/2 phase retarder and/or a λ/4 phase retarder. The polarizer may also be a film type or a liquid crystal-coated type. The film type may include a stretchable synthetic resin film, and the liquid crystal-coated type may include liquid crystals formed in a certain arrangement. Each of the phase retarder and polarizer may further include a protective film. The retarder and polarizer themselves or the protective film may be defined as the base layer of the anti-reflection layer CU.

A touch insulating layer 400 may be further disposed between the input sensing layer TU and the anti-reflection layer CU (e.g., in the z direction). The touch insulating layer 400 may include an organic material such as an acrylic polymer or a siloxane-based polymer, and may include inorganic nanoparticles to increase a refractive index. The touch insulating layer 400 may be applied using inkjet printing, screen printing, or the like. The touch insulating layer 400 may be arranged in the display area DA and a portion of the peripheral area PA, but may not be arranged in the bending area BA.

As will be described later, a display apparatus according to a comparative example may include a bending protection layer in which the touch insulating layer 400 continuously extends to the bending area BA. However, when applying a tight bending structure to reduce a product size, it may be difficult to reduce the product size due to the thickness of the bending protection layer. In the display apparatus 1, an organic film laminated structure to be described later may be applied to the bending area BA which excludes a bending protection layer, thereby reducing the strain of the bending area BA when applying a tight bending structure.

The display apparatus 1 may further include a cover window WU positioned on the display unit 10. The cover window WU may be a type of cover that protects the display apparatus 1 against external impacts, etc. The cover window WU may be made of a transparent and hard material, such as glass or plastic, to allow a user to view an image displayed on a screen of the display unit 10.

A protective film PF may be positioned below the substrate 100 (e.g., in the -z direction). The protective film PF may be a film made of a polymer such as polyethylene terephthalate, polyethylene naphthalate, polyimide, or polyethylene sulfide, and may be attached to the substrate 100 by an adhesive. The protective film PF may be positioned to cover the entire rear surface of the substrate 100, but may not be positioned on the bending area BA to reduce bending stress and curvature radius of the bending area BA.

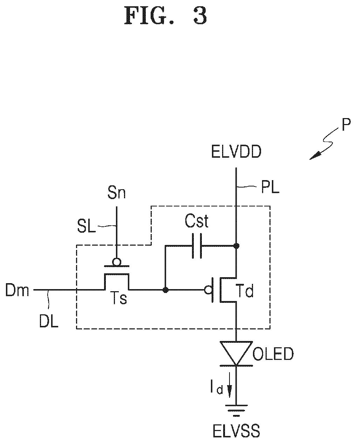

FIG. 3 is an equivalent circuit diagram of a pixel that may be included in a display apparatus.

Referring to FIG. 3, each of the pixels P may include a pixel circuit PC connected to the scan line SL and the data line DL, and an organic light-emitting diode OLED connected to the pixel circuit PC.

The pixel circuit PC may include a driving thin-film transistor Td, a switching thin-film transistor Ts, and a storage capacitor Cst. The switching thin-film transistor Ts may be connected to the scan line SL and the data line DL, and may transmit a data signal Dm input through the data line DL to the driving thin-film transistor Td according to a scan signal Sn input through the scan line SL.

The storage capacitor Cst may be connected to the switching thin-film transistor Ts and the driving voltage line PL, and may store a voltage corresponding to a difference between a voltage transmitted from the switching thin-film transistor Ts and a driving voltage ELVDD supplied to the driving voltage line PL.

The driving thin-film transistor Td may be connected to the driving voltage line PL and the storage capacitor Cst, and may control a driving current, which flows in the organic light-emitting diode OLED from the driving voltage line PL, in response to a voltage value stored in the storage capacitor Cst. The organic light-emitting diode OLED may emit light with a certain brightness depending on a driving current I_{d}.

In FIG. 3, the pixel circuit PC includes two thin-film transistors and one storage capacitor is described, but is not necessarily limited thereto. For example, the pixel circuit PC may include seven thin-film transistors and one storage capacitor. The pixel circuit PC may include two or more storage capacitors.

FIG. 4 is a schematic cross-sectional view of a cross-section taken along line I-I' of the display apparatus of FIG. 1.

For convenience of explanation, FIG. 4 omits the input sensing layer TU (see FIG. 2), the anti-reflection layer CU, and the cover window WU, and only shows the display layer. The display layer may include light-emitting diodes arranged on the substrate 100 to correspond to the display area DA. In this regard, FIG. 4 illustrates one light-emitting diode, for example, one organic light-emitting diode OLED.

First, a structure on the display area DA will be described with reference to FIG. 4. As described above, the display area DA may be included in the first area 1A.

A barrier layer 110 may be arranged on the substrate 100 (e.g., disposed directly thereon in the z direction). A buffer layer 111 may be arranged on the barrier layer 110 (e.g., disposed directly thereon in the z direction). The buffer layer 111 may suppress impurities from entering various elements, which are arranged on the substrate 100, through the substrate 100.

A pixel circuit PC including a thin-film transistor TFT may be arranged on the buffer layer 111 (e.g., disposed directly thereon in the z direction). The thin-film transistor TFT may include a semiconductor layer A, a gate electrode G overlapping a channel area of the semiconductor layer A (e.g., in the z direction), and a first electrode layer 120 on the gate electrode G. The first electrode layer 120 may include a source electrode S and a drain electrode D connected to a source area and a drain area of the semiconductor layer A, respectively. A gate insulating layer 112 may be interposed between the semiconductor layer A and the gate electrode G (e.g., in the z direction), and a first interlayer insulating layer 113 and a first via insulating layer 116 may be arranged between the gate electrode G and the first electrode layer 120 (e.g., in the z direction).

The semiconductor layer A may include a channel area and a source area and a drain area doped with impurities. The semiconductor layer A may include a silicon semiconductor material. The semiconductor layer A may include polysilicon or amorphous silicon. The semiconductor layer A may include an oxide semiconductor material.

A plurality of thin-film transistors TFTs may be included within the pixel circuit PC, and some of the plurality of thin-film transistors TFTs may include a silicon semiconductor material, while other thin-film transistors TFTs may include an oxide semiconductor material. in which the semiconductor layer A includes an oxide semiconductor material, the semiconductor layer A may include an oxide of at least one material selected from a group which consists of indium (In), gallium (Ga), tin (Sn), zirconium (Zr), hafnium (Hf), titanium (Ti), and zinc (Zn).

The gate insulating layer 112 may include an inorganic insulating material, such as silicon oxide (SiO2), silicon nitride (SiNx), or silicon oxynitride (SiOxNy), and may be a single-layer or multilayer structure including the aforementioned materials.

The gate electrode G may include a low-resistance conductive material, such as molybdenum (Mo), aluminum (Al), copper (Cu), and/or titanium (Ti), and may have a single-layer or multilayer structure made of the aforementioned materials.

The first interlayer insulating layer 113 may include an inorganic insulating material, such as silicon oxide (SiO2), silicon nitride (SiNx), or silicon oxynitride (SiOxNy), and may be a single-layer or multilayer structure including the aforementioned materials.

The first via insulating layer 116 may be arranged on the pixel circuit PC to planarize a step generated due to the pixel circuit PC. The first via insulating layer 116 may be formed of an organic film, such as an acrylic resin, an epoxy resin, a phenolic resin, a polyamide resin, or a polyimide resin. These materials may be used alone or in combination.

A first electrode layer 120 may be arranged on the first via insulating layer 116 (e.g., disposed directly thereon in the z direction). The first electrode layer 120 may be connected to the source region and drain region of the semiconductor layer A through a contact hole which is formed through the first via insulating layer 116. The first electrode layer 120 may include aluminum (Al), molybdenum (Mo), titanium (Ti), and/or copper (Cu), and may be a single-layer or multilayer structure formed of the aforementioned materials. For example, the first electrode layer 120 may have a three-layer structure of titanium layer/aluminum layer/titanium layer.

A second via insulating layer 117 may be arranged on the first via insulating layer 116 and the first electrode layer 120 (e.g., disposed directly thereon in the z direction). The second via insulating layer 117 may be formed of an organic film, such as an acrylic resin, an epoxy resin, a phenolic resin, a polyamide resin, or a polyimide resin. These materials may be used alone or in combination.

A second electrode layer 140 may be arranged on the second via insulating layer 117 (e.g., disposed directly thereon in the z direction). The second electrode layer 140 may be connected to the first electrode layer 120 through a contact hole which is formed through the second via insulating layer 117. A thin-film transistor TFT and a pixel electrode 210 may be electrically connected through the first electrode layer 120 and the second electrode layer 140. The second electrode layer 140 may include aluminum (Al), molybdenum (Mo), titanium (Ti), and/or copper (Cu), and may be a single-layer or multilayer structure formed of the aforementioned materials. For example, the second electrode layer 140 may have a three-layer structure of titanium layer/aluminum layer/titanium layer.

A third via insulating layer 118 may be arranged on the second via insulating layer 117 and the second electrode layer 140 (e.g., disposed directly thereon in the z direction). The third via insulating layer 118 may be formed of an organic film, such as acrylic resin, epoxy resin, phenolic resin, polyamide resin, or polyimide resin. These materials may be used alone or in combination.

The pixel electrode 210 may be disposed on the third via insulating layer 118 (e.g., disposed directly thereon in the z direction). The pixel electrode 210 may include a reflective film including silver (Ag), magnesium (Mg), aluminum (Al), platinum (Pt), palladium (Pd), gold (Au), nickel (Ni), neodymium (Nd), iridium (Ir), chromium (Cr), or a compound thereof. The pixel electrode 210 may include a reflective film including the material described above, and a transparent conductive film disposed on and/or below the reflective film. The transparent conductive film may include indium tin oxide (ITO), indium zinc oxide (IZO), zinc oxide (ZnO), indium oxide (In2O3), indium gallium oxide (IGO), or aluminum zinc oxide (AZO). The pixel electrode 210 may have a three-layer structure of sequentially stacked ITO layer/Ag layer/ITO layer.

A pixel defining layer 119 may cover an edge (e.g., lateral edges) of the pixel electrode 210 and may include an opening through which a center of the pixel electrode 210 is exposed. The pixel defining layer 119 may include an organic insulating material, such as benzocyclobutene (BCB), polyimide, or hexamethyldisiloxane (HMDSO). An emission area EA may be defined through the opening of the pixel defining layer 119, and red light, green light, or blue light may be emitted through the emission area EA. The area or width of the emission area EA may define the area or width of a pixel.

A spacer 121 may be formed on the pixel defining layer 119 (e.g., disposed directly thereon in the z direction). The spacer 121 may suppress damages on layers below the spacer 121 due to a mask in the process of forming an intermediate layer 220 and the like to be described later. The spacer 121 may include the same material as or a different material from the pixel defining layer 119. For example, in an example in which the spacer 121 includes the same material as the pixel defining layer 119, the spacer 121 and the pixel defining layer 119 may be formed integrally with each other through a half-tone mask.

The pixel defining layer 119 may be black. The pixel defining layer 119 may include a light-shielding material and may be formed as a black layer. The light-shielding material may include resin or paste containing carbon black, carbon nanotubes, or black dye, metal particles, for example, nickel, aluminum, molybdenum, and alloys thereof, metal oxide particles (e.g., chromium oxide), or metal nitride particles (e.g., chromium nitride). In an example in which the pixel defining layer 119 includes a light-shielding material, external reflections due to metal structures arranged below the pixel defining layer 119 may be reduced.

As described above, when the spacer 121 includes the same material as the pixel defining layer 119, the spacer 121 and the pixel defining layer 119 may be formed integrally with each other through the half-tone mask. Therefore, when the pixel defining layer 119 is formed as the black layer, the spacer 121 may also be black.

The intermediate layer 220 may include an emission layer which overlaps the pixel electrode 210 (e.g., in the z direction). The emission layer may include an organic material. The emission layer may include a high-molecular organic material or a low-molecular organic material which emits light of a certain color. The emission layer may be formed through a deposition process using a mask as described above.

A first functional layer and a second functional layer may be arranged below and/or above the emission layer, respectively. Unlike the emission layer being patterned for each pixel, the first functional layer and the second functional layer may be provided integrally over the entire display area DA.

The first functional layer may be single-layer or a multilayer. For example, in an example in which the first functional layer is formed of a high-molecular material, the first functional layer may be a hole transport layer (HTL) with a single-layer structure, and may be formed of poly-(3,4)-ethylene-dihydroxy thiophene (PEDOT) or polyaniline (PANI). In an example in which the first functional layer is formed of a low-molecular material, the first functional layer may include a hole injection layer (HIL) and a hole transport layer (HTL).

A counter electrode 230 may be made of a conductive material having a relatively low work function. For example, in an example the counter electrode 230 may include a (semi)transparent layer including silver (Ag), magnesium (Mg), aluminum (Al), nickel (Ni), chromium (Cr), lithium (Li), calcium (Ca), or an alloy thereof. Alternatively, the counter electrode 230 may further include a layer, such as ITO, IZO, ZnO or In2O3, on the (semi)transparent layer including the aforementioned materials. The counter electrode 230 may include silver (Ag) and magnesium (Mg).

The stacked structure of the pixel electrode 210, the intermediate layer 220, and the counter electrode 230, which are sequentially stacked, may form a light-emitting diode, such as an organic light-emitting diode OLED. The display layer which includes the pixel circuit PC, the insulating layers, and the organic light-emitting diode OLED may be covered with a thin-film encapsulation layer TFE.

The thin-film encapsulation layer TFE may include first and second inorganic encapsulation layers 310 and 330 and an organic encapsulation layer 320 therebetween (e.g., in the z direction).

The first and second inorganic encapsulation layers 310 and 330 may each include one or more inorganic insulating materials. The inorganic insulating material may include aluminum oxide, titanium oxide, tantalum oxide, hafnium oxide, zinc oxide, silicon oxide, silicon nitride, or/and silicon oxynitride. The first and second inorganic encapsulation layers 310 and 330 may be formed through chemical vapor deposition.

The organic encapsulation layer 320 may include a polymer-based material. The polymer-based material may include acrylic resin, epoxy resin, polyimide, and polyethylene. For example, the organic encapsulation layer 320 may include an acrylic resin, e.g., polymethyl methacrylate, polyacrylic acid, etc. The organic encapsulation layer 320 may be formed by curing a monomer or applying a polymer.

The thin-film encapsulation layer TFE may cover the entire display area DA and may extend toward the peripheral area PA to cover a portion of the peripheral area PA. The thin-film encapsulation layer TFE may extend to the peripheral area PA of the driving power supply line 60 (see FIG. 1).

An inorganic insulating layer IOL which includes the barrier layer 110, the buffer layer 111, the gate insulating layer 112, and the first interlayer insulating layer 113 may be arranged to cover the display area DA and the peripheral area PA. The inorganic insulating layer IOL may have an opening OP corresponding to the bending area BA. In FIG. 4, it is illustrated that the entire inorganic insulating layer IOL corresponding to the bending area BA has been removed. However, a portion or all of the barrier layer 110 or portions or all of the barrier layer 110 and the buffer layer 111 may remain without being removed. Here, the area of the opening OP may be defined by the area of the narrowest opening among openings of the barrier layer 110, the buffer layer 111, and the first interlayer insulating layer 113, which constitute the inorganic insulating layer IOL, and FIG. 4 illustrates that the area of the opening OP is defined by the area of the opening of the barrier layer 110. As such, a portion or all of the inorganic insulating layer IOL corresponding to the bending area BA may be removed, thereby suppressing cracks from propagating due to the inorganic insulating layer IOL when bending the substrate 100.

A lower organic layer 800 may be arranged on the bending area BA. The lower organic layer 800 may include the same material as the first via insulating layer 116. As used herein, when "layer A" and "layer B" include the same material as each other, it may mean that "layer A" and "layer B" are formed by the same process. Therefore, in an example in which the lower organic layer 800 includes the same material as the first via insulating layer 116, the lower organic layer 800 and the first via insulating layer 116 may be formed simultaneously.

The lower organic layer 800 may fill at least a portion of the opening OP of the inorganic insulating layer IOL. In FIG. 4, the lower organic layer 800 is illustrated as filling the entirety of the opening OP.

A first conductive layer 135 may be arranged on the lower organic layer 800 (e.g., disposed directly thereon in the z direction). The first conductive layer 135 may extend from the first area 1A to the second area 2A through the bending area BA. The first conductive layer 135 may be positioned on the inorganic insulating layer IOL, such as the first interlayer insulating layer 113, in an area where the lower organic layer 800 is not disposed. The first conductive layer 135 may include the same material as the first electrode layer 120. Therefore, in an example the first conductive layer 135 and the first electrode layer 120 may be formed simultaneously.

The display apparatus 1 may include second conductive layers 131a and 131b in addition to the first conductive layer 135. The second conductive layers 131a and 131b may be arranged on the first area 1A or the second area 2A to be located on a different layer from a layer where the first conductive layer 135 is positioned, and may be electrically connected to the first conductive layer 135.

As shown in FIG. 4, the second conductive layers 131a and 131b are made of the same material and positioned on the same layer as the gate electrode G of the thin-film transistor TFT, such as positioned on the gate insulating layer 112 (e.g., disposed directly thereon in the z direction). Also, the first conductive layer 135 is shown as coming into direct contact with the second conductive layers 131a and 131b through contact holes which are formed through the first interlayer insulating layer 113.

The second conductive layer 131a located on the first area 1A may be electrically connected to the thin-film transistor TFT or the like within the display area DA, and thus the first conductive layer 135 may be electrically connected to the thin-film transistor or the like within the display area DA through the second conductive layer 131a. Of course, the second conductive layer 131b located on the second area 2A may also be electrically connected to the thin-film transistor TFT or the like within the display area DA by the first conductive layer 135. For example, the first conductive layer 135 may be electrically connected to the pad unit 40 (see FIG. 1) through the second conductive layer 131b located on the second area 2A.

referring to FIG. 4 again, an upper organic layer 900 may be arranged on the first conductive layer 135 (e.g., disposed directly thereon in the z direction). The upper organic layer 900 may include at least one or more organic insulating layers 901, 902, and 903 (e.g., consecutively stacked in the z direction). In FIG. 4, the upper organic layer 900 may include a first organic insulating layer 901, a second organic insulating layer 902, and a third organic insulating layer 903, but is not necessarily limited thereto and some of these may be omitted or additional organic insulating layers may be included.

As explained above, it may be assumed, as a comparative example, that a display apparatus includes a bending protection layer covering a bending area. In this comparative example, the display apparatus may adjust a position of a stress neutral plane (NP) and protect the first conductive layer by using the bending protection layer. However, the bending protection layer may cause problems, such as an increase in bending diameter and an increase in dead space at the bottom of the display apparatus, due to a thickness of the bending protection layer reaching approximately 70 µm.

Additionally, to reduce a product size, a display apparatus may adopt a tight bending structure which is obtained by initially bending the bending area along a bending axis, and then shifting the second area towards the center of the display area. However, in a comparative example in which the display apparatus is provided with the bending protection layer, a minimum application distance for applying the bending protection layer should be secured on the substrate, and there may be a limit to applying the tight bending structure due to the thickness of the bending protection layer.

In the display apparatus 1, a first organic insulating layer 901 having a first thickness, a second organic insulating layer 902 having a second thickness, and a third organic insulating layer 903 having a third thickness may be arranged on the first conductive layer 135, and the sum of the first thickness to the third thickness may be a preset thickness. This may result in protecting the first conductive layer 135 by adjusting the position of the stress neutral plane (NP) without employing a bending protection layer.

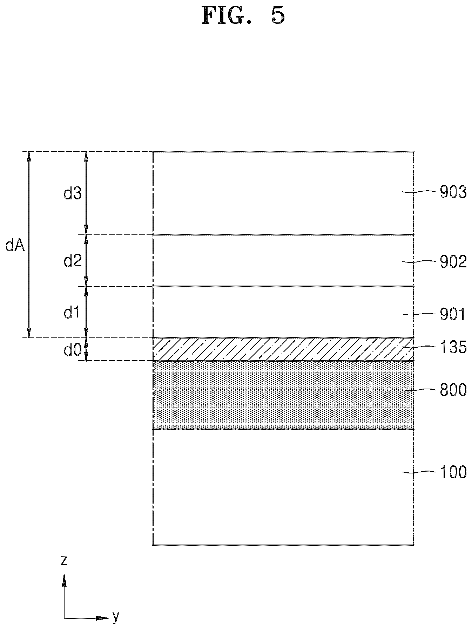

FIG. 5 is a diagram merely illustrating a part III of FIG. 4.

Referring to FIG. 5, the display apparatus 1 may include a first organic insulating layer 901 arranged on (e.g., directly thereon) the first conductive layer 135 and having a first thickness d1 (e.g., in the z direction), a second organic insulating layer 902 arranged on (e.g., directly thereon) the first organic insulating layer 901 and having a second thickness d2 (e.g., in the z direction), and a third organic insulating layer 903 arranged on (e.g., directly thereon) the second organic insulating layer 902 and having a third thickness d3 (e.g., in the z direction).

Each of the first organic insulating layer 901, the second organic insulating layer 902, and the third organic insulating layer 903 may include different materials from each other. However, they are not necessarily limited thereto. For example, the first organic insulating layer 901 and the third organic insulating layer 903 may include the same material as each other, and the second organic insulating layer 902 may include a different material from the first organic insulating layer 901 or the third organic insulating layer 903. The first organic insulating layer 901 and the second organic insulating layer 902 may include the same material as each other, and the third organic insulating layer 903 may include a different material from the first organic insulating layer 901 or the second organic insulating layer 902.

Referring to FIG. 4 again, the first organic insulating layer 901 may include the same material as the second via insulating layer 117. For example, the first organic insulating layer 901 and the second via insulating layer 117 may be formed by the same process.

The second organic insulating layer 902 may include the same material as the third via insulating layer 118. For example, the second organic insulating layer 902 and the third via insulating layer 118 may be formed by the same process.

The third organic insulating layer 903 may include the same material as the spacer 121. For example, the third organic insulating layer 903 and the spacer 121 may be formed by the same process.

In this instance, the total thickness dA (e.g. length in the z direction) of the first to third organic insulating layers 901, 902, and 903, such as the sum d1+d2+d3 of the first to third thicknesses, may be in a range of about 2 to about 30 times a thickness d0 (e.g., length in the z direction) of the first conductive layer 135.

The thickness d0 of the first conductive layer 135 is not necessarily limited, but may be smaller than any one of the first thickness d1 of the first organic insulating layer 901, the second thickness d2 of the second organic insulating layer 902, and the third thickness d3 of the third organic insulating layer 903. For example, the thickness d0 of the first conductive layer 135 may be in the range of about 200nm (2000 Å) to about 400nm (4000 Å), and the total thickness dA of the first to third organic insulating layers 901, 902, and 903 may be in a range of about 5 µm to about 10 µm when it is 25 times the thickness d0 of the first conductive layer 135.

The thickness of one of the first organic insulating layer 901 through the third organic insulating layer 903 may be greater than the thickness of another organic insulating layer. The third thickness d3 of the third organic insulating layer 903 may be greater than the first thickness d1 of the first organic insulating layer 901 or the second thickness d2 of the second organic insulating layer 902. In this example, the third thickness d3 of the third organic insulating layer 903 may be less than or equal to the sum of the first thickness d1 of the first organic insulating layer 901 and the second thickness d2 of the second organic insulating layer 902.

For example, the third thickness d3 of the third organic insulating layer 903 may be twice the first thickness d1 of the first organic insulating layer 901 or the second thickness d2 of the second organic insulating layer 902. The first thickness d1 of the first organic insulating layer 901 or the second thickness d2 of the second organic insulating layer 902 may be about 1.5 µm, and the third thickness d3 of the third organic insulating layer 903 may be about 3.0 µm.

The total thickness dA of the first organic insulating layer 901, the second organic insulating layer 902, and the third organic insulating layer 903 may be greater than or equal to about 6.0 µm.

In the display apparatus 1, the total thickness dA of the first to third organic insulating layers 901, 902, and 903 may be preset (e.g., predetermined), and the third thickness d3 of the third organic insulating layer 903, which is the outermost insulating layer located on the bending area BA, may be set to be greater than the thicknesses of the other organic insulating layers, thereby adjusting the position of the stress neutral plane (NP).

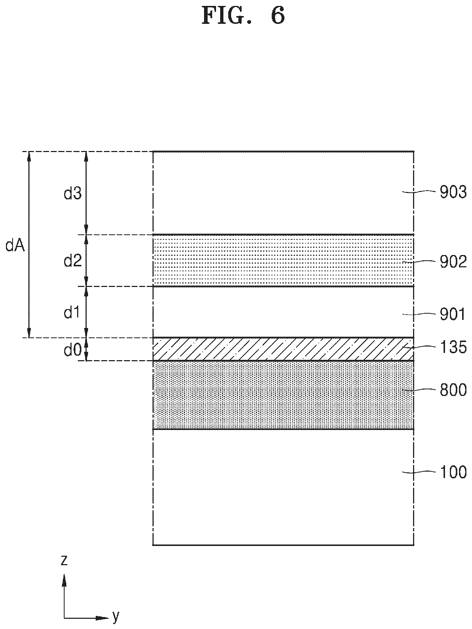

FIG. 6 is a diagram illustrating the part III of FIG. 4.

Referring to FIG. 6, the display apparatus 1 may include a first organic insulating layer 901 arranged on (e.g., directly thereon) the first conductive layer 135 and having a first thickness d1 (e.g., in the z direction), a second organic insulating layer 902 arranged on (e.g., directly thereon) the first organic insulating layer 901 and having a second thickness d2 (e.g., in the z direction), and a third organic insulating layer 903 arranged on (e.g., directly thereon) the second organic insulating layer 902 and having a third thickness d3 (e.g., in the z direction).

Referring to FIG. 4 again, the first organic insulating layer 901 may include the same material as the second via insulating layer 117. For example, the first organic insulating layer 901 and the second via insulating layer 117 may be formed by the same process.

The second organic insulating layer 902 may include the same material as the pixel defining layer 119. For example, the second organic insulating layer 902 and the pixel defining layer 119 may be formed by the same process. The second organic insulating layer 902 may include a light-shielding material.

The third organic insulating layer 903 may include the same material as the spacer 121. For example, the third organic insulating layer 903 and the spacer 121 may be formed by the same process.

In this instance, the total thickness dA of the first to third organic insulating layers 901, 902, and 903, such as the sum d1+d2+d3 of the first to third thicknesses, may be in a range of about 2 to about 30 times a thickness d0 of the first conductive layer 135. The total thickness dA of the first organic insulating layer 901, the second organic insulating layer 902, and the third organic insulating layer 903 may be greater than or equal to about 6.0 µm.

The second thickness d2 of the second organic insulating layer 902 or the first thickness d1 of the first organic insulating layer 901 may be the same, and the third thickness d3 of the third organic insulating layer 903 may be twice the thickness d1 of the first organic insulating layer 901. For example, the first thickness d1 of the first organic insulating layer 901 or the second thickness d2 of the second organic insulating layer 902 may be about 1.5 µm, and the third thickness d3 of the third organic insulating layer 903 may be about 3.0 µm.

As another example, the second thickness d2 of the second organic insulating layer 902 may be less than the first thickness d1 of the first organic insulating layer 901. The first thickness d1 of the first organic insulating layer 901 may be about 1.5 µm, and the second thickness d2 of the second organic insulating layer 902 may be about 1.0 µm.

The total thickness dA of the first organic insulating layer 901, the second organic insulating layer 902, and the third organic insulating layer 903 must satisfy a preset thickness value. In this example, the third thickness d3 of the third organic insulating layer 903 may increase as the second thickness d2 of the second organic insulating layer 902 decreases. For example, in an example in which the total thickness dA of the first organic insulating layer 901, the second organic insulating layer 902, and the third organic insulating layer 903 is about 6.0 µm and the second thickness d2 of the second organic insulating layer 902 is about 1.0 µm, the third thickness d3 of the third organic insulating layer 903 may be about 3.5 µm.

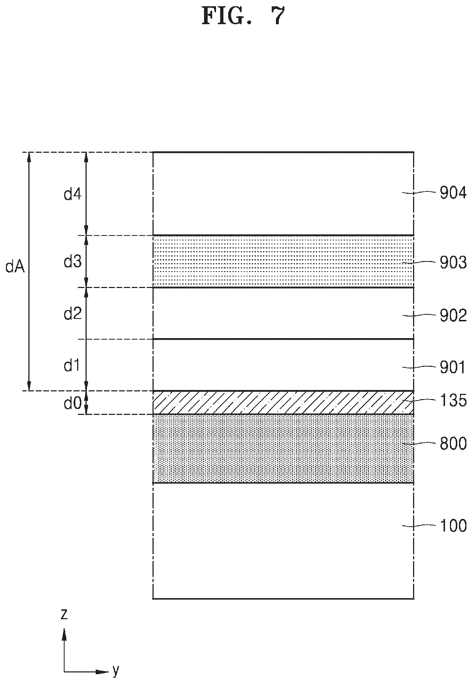

FIG. 7 is a diagram illustrating other examples of the part III of FIG. 4;

Referring to FIG. 7, the display apparatus 1 may include a first organic insulating layer 901 arranged on (e.g., directly thereon) a first conductive layer 135 and having a first thickness d1, a second organic insulating layer 902 arranged on (e.g., directly thereon) the first organic insulating layer 901 and having a second thickness d2, a third organic insulating layer 903 arranged on (e.g., directly thereon) the second organic insulating layer 902 and having a third thickness d3, and a fourth organic insulating layer 904 arranged on (e.g., directly thereon) the third organic insulating layer 903 and having a fourth thickness d4.

Referring to FIG. 4 again, the first organic insulating layer 901 may include the same material as the second via insulating layer 117. For example, the first organic insulating layer 901 and the second via insulating layer 117 may be formed by the same process.

The second organic insulating layer 902 may include the same material as the third via insulating layer 118. For example, the second organic insulating layer 902 and the third via insulating layer 118 may be formed by the same process.

The third organic insulating layer 903 may include the same material as the pixel defining layer 119. For example, the third organic insulating layer 903 and the pixel defining layer 119 may be formed by the same process. The third organic insulating layer 903 may include a light-shielding material.

The fourth organic insulating layer 904 may include the same material as the spacer 121. For example, the fourth organic insulating layer 904 and the spacer 121 may be formed by the same process.

In this instance, the total thickness dA (e.g., length in the z direction) of the first to fourth third organic insulating layers 901, 902, 903, and 904, such as the sum d1+d2+d3+d4 of the first to fourth thicknesses, may be in a range of about 2 to about 30 times a thickness d0 of the first conductive layer 135. The total thickness dA of the first organic insulating layer 901, the second organic insulating layer 902, the third organic insulating layer 903, and the fourth organic insulating layer 904 may be greater than or equal to about 6.0 µm.

The first thickness d1 of the first organic insulating layer 901, the second thickness d2 of the second organic insulating layer 902, the third thickness d3 of the third organic insulating layer 903, and the fourth thickness d4 of the fourth organic insulating layer 904 may have substantially the same ratio.

In some examples, the third thickness d3 of the third organic insulating layer 903 may have a thickness relatively lower (e.g., thinner) than those of the other organic insulating layers. In this example, the fourth thickness d4 of the fourth organic insulating layer 904 may be increased by the relatively lowered thickness of the third organic insulating layer 903. For example, the first thickness d1 of the first organic insulating layer 901, the second thickness d2 of the second organic insulating layer 902, the third thickness d3 of the third organic insulating layer 903, and the fourth thickness d4 of the fourth organic insulating layer 904 may have a ratio of 3:3:2:4.

In the display apparatus 1 with this structure, the total thickness dA of the first to fourth organic insulating layers 901, 902, 903, and 904 may be preset (e.g., predetermined), and the fourth thickness d4 of the fourth organic insulating layer 904 may be set to be greater than the thicknesses of the other organic insulating layers, thereby adjusting the position of the stress neutral plane (NP).

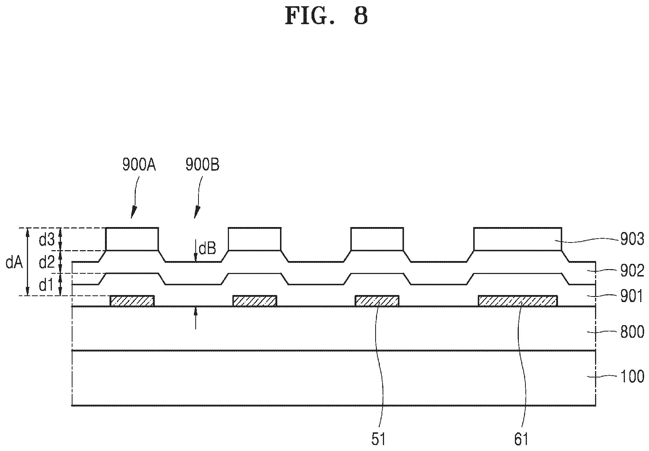

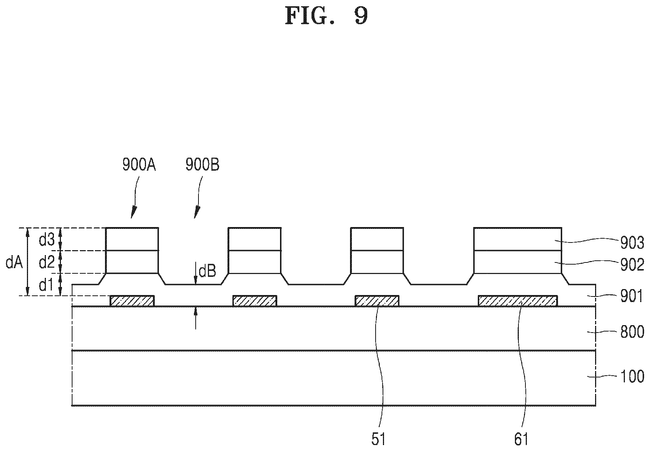

FIGS. 8 and 9 are schematic cross-sectional views taken along line II-II' of FIG. 2. FIGS. 8 and 9 are diagrams for explaining a display apparatus.

The display apparatus 1 described above is configured to adjust the position of the stress neutral plane (NP) and reduce the strain in the bending area BA through the stacked structure of the organic insulating layers arranged on the bending area BA without a separate bending protection layer. Therefore, the total thickness dA of the first to third organic insulating layers 901, 902, and 903 may be uniform on the bending area BA.

In contrast, the first to third organic insulating layers 901, 902, and 903 may form certain patterns on the bending area BA.

In some examples, the display apparatus 1 may include a first organic insulating layer 901 arranged on (e.g., directly thereon) a plurality of wires 51 and 61 and having a first thickness d1 (e.g., in the z direction), a second organic insulating layer 902 arranged on (e.g., directly thereon) the first organic insulating layer 901 and having a second thickness d2 (e.g., in the z direction), and a third organic insulating layer 903 arranged on (e.g., directly thereon) the second organic insulating layer 902 and having a third thickness d3 (e.g., in the z direction).

Referring back to FIGS. 1 and 4, the plurality of wires 51 and 61 may extend from the first area 1A to the second area 2A through the bending area BA and may be arranged on the substrate 100. The plurality of wires 51 and 61 may be the first conductive layer 135. The plurality of wires 51 and 61 may include the same material as the first electrode layer 120. Therefore, the plurality of wires 51 and 61 and the first electrode layer 120 may be formed simultaneously. The plurality of wires 51 and 61 may be arranged to be spaced apart from each other along one direction (e.g., the +x direction).

At least one of the first to third organic insulating layers 901, 902, and 903 may include a plurality of insulating patterns which are arranged to be spaced apart from each other (e.g., in the z direction). The first organic insulating layer 901 may be uniformly formed on (e.g., directly thereon) the plurality of wires 51 and 61, the second organic insulating layer 902 may be uniformly formed on (e.g., directly thereon) the first organic insulating layer 901, and the third organic insulating layer 903 may include a plurality of insulating patterns.

The plurality of insulating patterns included in the third organic insulating layer 903 may overlap the plurality of wires 51 and 61 (e.g., in the z direction) which are arranged with being spaced apart from each other. In other words, the third organic insulating layer 903 may include a plurality of insulating patterns formed on the plurality of wires 51 and 61 and extending along the plurality of wires 51 and 61.

With the structure, an organic insulating layer, which includes the first organic insulating layer 901, the second organic insulating layer 902, and the third organic insulating layer 903, may have a pattern area 900A and a non-pattern area 900B with relatively different thicknesses (e.g., in the z direction). A thickness dA of the pattern area 900A may be greater than a thickness dB of the non-pattern area 900B due to the insulating pattern of the third organic insulating layer 903.

A width of the pattern area 900A (e.g., in a plan view) may be greater than or equal to widths of the wires 51 and 61 (e.g., in a plan view) that it overlaps. The pattern area 900A may form the organic insulating layer with the thickness relatively greater than the non-pattern area 900B on the plurality of wires 51 and 61, which may allow for the adjustment of the position of the stress neutral plane (NP) in the area where the plurality of wires 51 and 61 are arranged.

The first organic insulating layer 901, the second organic insulating layer 902, and the third organic insulating layer 903 may each include different materials from each other. However, they are not necessarily limited thereto. The first organic insulating layer 901 and the third organic insulating layer 903 may include the same material, and the second organic insulating layer 902 may include a different material from the first organic insulating layer 901 or the third organic insulating layer 903. The first organic insulating layer 901 and the second organic insulating layer 902 may include the same material, and the third organic insulating layer 903 may include a different material from the first organic insulating layer 901 or the second organic insulating layer 902.

Referring to FIG. 4 again, the first organic insulating layer 901 may include the same material as the second via insulating layer 117. For example, the first organic insulating layer 901 and the second via insulating layer 117 may be formed by the same process.

The second organic insulating layer 902 may include the same material as the third via insulating layer 118. For example, the second organic insulating layer 902 and the third via insulating layer 118 may be formed by the same process.

The third organic insulating layer 903 may include the same material as the spacer 121. For example, the third organic insulating layer 903 and the spacer 121 may be formed by the same process. The plurality of insulating patterns of the third organic insulating layer 903 may be patterned together with the spacer 121 in the same process. Alternatively, the third organic insulating layer 903 may form the plurality of insulating patterns by having different thicknesses in the pattern area 900A and the non-pattern area 900B. The third organic insulating layer 903 may be formed through a half-tone mask.

In an area where the plurality of insulating patterns overlap the plurality of wires, such as in the pattern area 900A, the thickness of one of the first organic insulating layer 901 through the third organic insulating layer 903 may be greater than the thickness of another organic insulating layer. The third thickness d3 of the third organic insulating layer 903 may be greater than the first thickness d1 of the first organic insulating layer 901 or the second thickness d2 of the second organic insulating layer 902. The third thickness d3 of the third organic insulating layer 903 may be less than or equal to the sum of the first thickness d1 of the first organic insulating layer 901 and the second thickness d2 of the second organic insulating layer 902.

For example, the third thickness d3 of the third organic insulating layer 903 may be twice the first thickness d1 of the first organic insulating layer 901 or the second thickness d2 of the second organic insulating layer 902. The first thickness d1 of the first organic insulating layer 901 or the second thickness d2 of the second organic insulating layer 902 may be about 1.5 µm, and the third thickness d3 of the third organic insulating layer 903 may be about 3.0 µm.

The total thickness dA of the first organic insulating layer 901, the second organic insulating layer 902, and the third organic insulating layer 903 may be greater than or equal to about 6.0 µm.

The display apparatus 1 may further include a fourth organic insulating layer 904 arranged on the third organic insulating layer 903. The stacked structure including the fourth organic insulating layer 904, as illustrated in FIG. 7, may be applied to the pattern area 900A.

In this example, the first organic insulating layer 901 may include the same material as the second via insulating layer 117. For example, the first organic insulating layer 901 and the second via insulating layer 117 may be formed by the same process. The second organic insulating layer 902 may include the same material as the third via insulating layer 118. For example, the second organic insulating layer 902 and the third via insulating layer 118 may be formed by the same process. The third organic insulating layer 903 may include the same material as the pixel defining layer 119. For example, the third organic insulating layer 903 and the pixel defining layer 119 may be formed by the same process. The fourth organic insulating layer 904 may include the same material as the spacer 121. For example, the fourth organic insulating layer 904 and the spacer 121 may be formed by the same process.

The third organic insulating layer 903 may include a light-shielding material.

In the pattern area 900A, the first thickness d1 of the first organic insulating layer 901, the second thickness d2 of the second organic insulating layer 902, the third thickness d3 of the third organic insulating layer 903, and the fourth thickness d4 of the fourth organic insulating layer 904 may have substantially the same ratio.

The third thickness d3 of the third organic insulating layer 903 may have a thickness relatively lower (e.g., thinner) than those of the other organic insulating layers. The fourth thickness d4 of the fourth organic insulating layer 904 may be increased by the relatively lowered thickness of the third organic insulating layer 903. For example, the first thickness d1 of the first organic insulating layer 901, the second thickness d2 of the second organic insulating layer 902, the third thickness d3 of the third organic insulating layer 903, and the fourth thickness d4 of the fourth organic insulating layer 904 may have a ratio of 3:3:2:4.

The display apparatus may adjust the position of the stress neutral plane (NP) in the plurality of wires, through the organic insulating layers, which have the pattern area 900A and the non-pattern area 900B with different thicknesses in the bending area, thereby reducing strain and simultaneously implementing an optimized structure of the organic insulating layers for applying a tight bending structure.

Referring to FIG. 9, At least one of the first to third organic insulating layers 901, 902, 903 may comprise a plurality of insulating patterns arranged to be spaced apart from each other. For example, a first organic insulating layer 901 may be uniformly formed on a plurality of wires 51 and 61, and each of a second organic insulating layer 902 and a third organic insulating layer 903 may include a plurality of insulating patterns.

The plurality of insulating patterns included in each of the second organic insulating layer 902 and the third organic insulating layer 903 may overlap the plurality of wires 51 and 61 (e.g., in the z direction) which are arranged to be spaced apart from each other. For example, each of the second insulating layer 902 and the third organic insulating layer 903 may include a plurality of insulating patterns formed on the plurality of wires 51 and 61 and extending along the plurality of wires 51 and 61.

A width of the plurality of insulating patterns of the second organic insulating layer 902 may be larger than a width of the plurality of insulating patterns of the third organic insulating layer 903. The plurality of insulating patterns of the second organic insulating layer 902 may be patterned at the same time when a through hole is formed through a third via insulating layer 118 after forming the second organic insulating layer 902 on the first organic insulating layer 901. The plurality of insulating patterns of the third organic insulating layer 903 may be patterned together with the spacer 121 after forming the third organic insulating layer 903 on the second organic insulating layer 903.

Alternatively, the plurality of insulating patterns of the second organic insulating layer 902 may be patterned together with the spacer 121 after forming the third organic insulating layer 903 on the second organic insulating layer 902.

In an area where the plurality of insulating patterns overlap the plurality of wires, such as in the pattern area 900A, the thickness of one of the first organic insulating layer 901 through the third organic insulating layer 903 may be greater than the thickness of another. The third thickness d3 of the third organic insulating layer 903 may be greater than the first thickness d1 of the first organic insulating layer 901 or the second thickness d2 of the second organic insulating layer 902. The third thickness d3 of the third organic insulating layer 903 may be less than or equal to the sum of the first thickness d1 of the first organic insulating layer 901 and the second thickness d2 of the second organic insulating layer 902.

In the display apparatus 1, the total thickness dA of the first to third organic insulating layers 901, 902, and 903 may be preset (e.g., predetermined), and some of the organic insulating layers may have insulating patterns having the width larger than the width of the plurality of wires, and the third thickness d3 of the third organic insulating layer 903, which is the outermost insulating layer disposed on the bending area BA, may be greater than those of the other organic insulating layers. Accordingly, the display apparatus 1 may be configured to more effectively adjust the position of the stress neutral plane (NP) corresponding to the plurality of wires in the bending area BA.

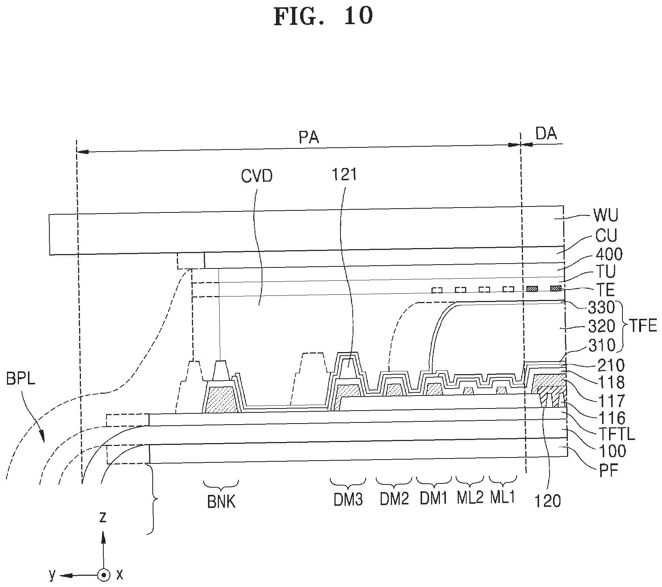

FIG. 10 is a cross-sectional view for comparing a display apparatus with a display apparatus according to a comparative example. A display apparatus according to a comparative example corresponds to an apparatus including a bending protection layer BPL, and is indicated by a dotted line in FIG. 10. A display apparatus is indicated by a solid line in FIG. 10. The display apparatus may include the same components as those in the previous examples, so redundant descriptions may be omitted for economy of explanation.

Referring to FIG. 10, a display apparatus may include a substrate 100, a thin-film transistor layer TFTL, a first electrode layer 120, a first via insulating layer 116, a second via insulating layer 117, a third via insulating layer 118, a pixel electrode 210, a thin-film encapsulation layer TFE, an input sensing layer TU, a touch insulating layer 400, an anti-reflection layer CU, and a cover window WU. The display apparatus may further include an adhesive layer between the anti-reflection layer CU and the cover window WU (e.g., in the z direction).

The substrate 100 may have a bending area BA located between a first area 1A and a second area 2A, as illustrated in FIG. 2. The substrate 100 may include various materials having a flexible or bendable characteristic.

The thin-film transistor layer TFTL may include thin-film transistors TFT and insulating layers (e.g., the buffer layer 111, the gate insulating layer 112, etc., see FIG. 4), as described above.

The first electrode layer 120 may electrically connect a semiconductor layer of the thin-film transistor layer TFTL and the pixel electrode 210 through a contact hole formed in the first via insulating layer 116. As illustrated in FIG. 4, the display apparatus may further include the second electrode layer 140 that is electrically connected to the first electrode layer 120 to thus be electrically connected to the pixel electrode 210.

A third dam DM3 may be formed on the first electrode layer 120 and extend in one direction (e.g., the +x direction) along a non-display area PA. A second dam DM2 and a first dam DM1 which extend parallel to the third dam DM3 may be further formed between the third dam DM3 and a display area DA. For example, the first dam DM1, the second dam DM2, and the third dam DM3 may be formed sequentially from the display area DA in another direction (e.g., the +y direction).

The first to third dams DM1, DM2, and DM3 may be formed to surround the display area DA of the display apparatus (e.g., in a plan view), and may be disposed to overlap (e.g., in the z direction) wires which are formed on the same layer as the first electrode layer 120 or the second electrode layer 140. For example, in an area where the wires extend in the other direction (e.g., the +y direction), the first to third dams DM1, DM2, and DM3 may extend in the one direction (e.g., the +x direction). The first to third dams DM1, DM2, and DM3 may be formed to suppress overflow of an organic material by controlling the flow of the organic material when forming the organic encapsulation layer 320 of the thin-film encapsulation layer TFE. The three dams are shown as being formed sequentially, but the shapes or number of dams are not necessarily limited thereto.

The first dam DM1 may be disposed on the first via insulating layer 116 and may include the second via insulating layer 117 and the third via insulating layer 118. The first dam DM1 may be disposed on the first via insulating layer 116 and may include the second via insulating layer 117 and a pixel defining layer 119.

The second dam DM2 may be disposed on the first via insulating layer 116 and may include the second via insulating layer 117 and the third via insulating layer 118The second dam DM2 may be disposed on the first via insulating layer 116 and may include the second via insulating layer 117 and the pixel defining layer 119.

The third dam DM3 may be disposed on the first via insulating layer 116 and may include the second via insulating layer 117, the third via insulating layer 118, and a spacer 121. The third dam DM3 may be disposed on the first via insulating layer 116 and may include the second via insulating layer 117, the pixel defining layer 119, and the spacer 121. Accordingly, the third dam DM3 may have a height higher than the second dam DM2 or the first dam DM1.

A first stacked structure ML1 may be disposed on the first via insulating layer 116 between the first dam DM1 and the display area DA, and have a height lower than the first dam DM1. The first stacked structure ML1 may include a portion of the second via insulating layer 117 and a portion of the third via insulating layer 118. Alternatively, the first stacked structure ML1 may include a portion of the second via insulating layer 117 and a portion of the pixel defining layer 119. The first stacked structure ML1 may be a stacked structure including an organic material.

A second stacked structure ML2 may be formed on the first via insulating layer 116 between the first stacked structure ML1 and the first dam DM1, and have a height lower than the first dam DM1. The second stacked structure ML2 may include a portion of the second via insulating layer 117 and a portion of the third via insulating layer 118. The second stacked structure ML2 may alternatively include a portion of the second via insulating layer 117 and a portion of the pixel defining layer 119. The second stacked structure ML2 may be a stacked structure including an organic material.

The first via insulating layer 116 may have a first height in the first dam DM1 and a second height lower than the first height in the first stacked structure ML1 and the second stacked structure ML2. The first via insulating layer 116 may be formed to have different heights using a half-tone mask or the like.

The pixel electrode 210 may be disposed to overlap (e.g., in the z direction) the entire first stacked structure ML1, the entire second stacked structure ML2, and at least a portion of the first dam DM1.

A bank BNK may be disposed outside the third dam DM3 (e.g., in a plan view). The bank BNK may be arranged to extend in the one direction (e.g., the +x direction) parallel to the third dam DM3 in the non-display area PA. The bank BNK may be a structure for supporting a mask when manufacturing a display panel. The bank BNK may be disposed on the thin-film transistor layer TFTL and may include the second via insulating layer 117, the third via insulating layer 118, and the spacer 121. The bank BNK may be disposed on the first via insulating layer 116 and may include the second via insulating layer 117, the pixel defining layer 119, and the spacer 121.

The thin-film encapsulation layer TFE may include first and second inorganic encapsulation layers 310 and 330 and an organic encapsulation layer 320 therebetween (e.g., in the z direction).

An inorganic encapsulation area CVD may be defined between the plurality of dams DM1, DM2, and DM3 and the bank BNK. The inorganic encapsulation area CVD may be a contact area between the first and second inorganic encapsulation layers 310 and 330 of the thin-film encapsulation layer TFE for encapsulating the display panel. The inorganic encapsulation area CVD may be an area where only an inorganic layer is disposed but an organic layer is not disposed.

An input sensing layer TU may be arranged on the thin-film encapsulation layer TFE and the inorganic encapsulation area CVD. Since the input sensing layer TU is arranged directly on the thin-film encapsulation layer TFE, there may be an advantage in that the thickness of the display apparatus 1 may be reduced, compared to an example in which a separate touch panel including the input sensing layer TU is attached on the thin-film encapsulation layer TFE.

The input sensing layer TU may include sensing electrodes TE for detecting a user's touch in a mutual capacitance manner, and sensing lines connecting (e.g., electrically connecting) the sensing electrodes TE and pads to each other. The sensing electrodes TE of the input sensing layer TU may be disposed in an area overlapping the display area DA, as illustrated in FIG. 10. Additionally, the sensing lines of the input sensing layer TU may be arranged to partially overlap the sensing electrodes TE. Accordingly, the non-display area PA of the display apparatus 1 may be minimized.

For example, the display apparatus 1 may minimize the non-display area PA, compared to the display apparatus according to the comparative example (dotted line), by arranging some of the sensing electrodes TE to overlap some of the sensing lines in the display area DA. Through this, the display apparatus 1 may minimize the non-display area PA while excluding the bending protection layer BPL, resulting in reducing the size of the display apparatus.

The anti-reflection layer CU may be arranged on the input sensing layer TU. The anti-reflection layer CU may include a color filter disposed to correspond to an emission area of the corresponding pixel P, and a light-shielding layer disposed to correspond to a non-emission area between the pixels P.

A touch insulating layer 400 may be further disposed between the input sensing layer TU and the anti-reflection layer CU (e.g., in the z direction). The touch insulating layer 400 may include an organic material such as an acrylic polymer or a siloxane-based polymer, and may include inorganic nanoparticles to increase a refractive index. The touch insulating layer 400 may be applied using inkjet printing, screen printing, or the like. In the present disclosure, the touch insulating layer 400 may be arranged in the display area DA and a portion of the peripheral area PA, but may not be arranged in the bending area BA.

The display apparatus according to the comparative example (dotted line) may include the bending protection layer BPL in which the touch insulating layer 400 continuously extends to the bending area BA. The thickness of the bending protection layer BPL may cause a difficulty in size reduction of the display apparatus when applying a tight bending structure. In contrast, in the display apparatus 1, an organic film stacked structure may be applied to the bending area BA, excluding a bending protection layer. This may result in reducing the strain of the bending area BA when applying the tight bending structure.

In the comparative example, a minimum margin distance may be required in the non-display area PA for applying the bending protection layer BPL. However, the display apparatus 1 does not require applying the bending protection layer BPL, and thus may reduce the non-display area PA by the minimum margin distance. The display apparatus 1 may narrow the distance between the plurality of dams DM1, DM2, and DM3 and the bank BNK, thereby reducing even the inorganic encapsulation area CVD. The display apparatus 1 may further include the cover window WU positioned on the display unit 10. The cover window WU may be a type of cover that protects the display apparatus 1 against external impacts, etc. The cover window WU may be made of a transparent and hard material, such as glass or plastic, to allow a user to view an image displayed on a screen of the display unit 10.

A protective film PF may be positioned below the substrate 100 (e.g., in the - z direction). The protective film PF may be a film made of polymer, such as polyethylene terephthalate, polyethylene naphthalate, polyimide, or polyethylene sulfide, and may be attached to the substrate 100 by an adhesive. The protective film PF may be positioned to cover the entire rear surface of the substrate 100, but may not be positioned in the bending area BA to reduce bending stress and curvature radius of the bending area BA.

### The Electronic Device

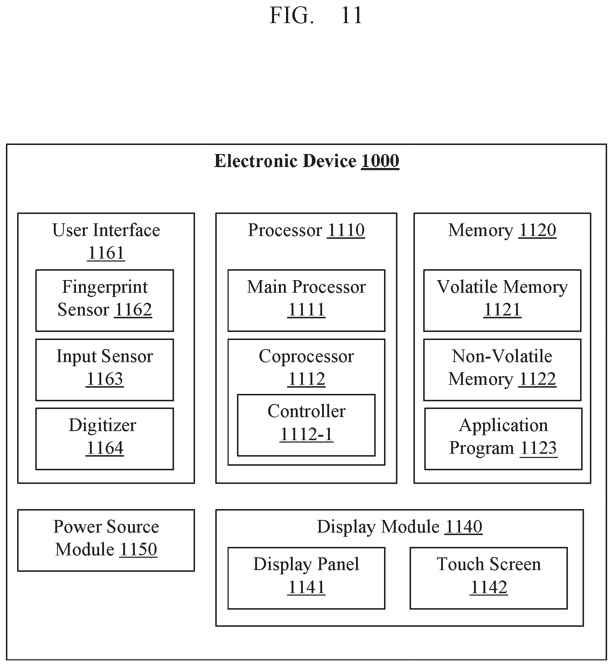

FIG. 11 is a diagram illustrating an electronic device. Referring to FIG. 11, the electronic device 1000 (e.g., an electronic apparatus) may output various information (e.g., images, text, music, etc.) through a display module 1140, which, for example, may correspond to the display device shown in FIG. 1. When a processor 1110 executes an application stored in a memory 1120, the display module 1140 may provide application information to a user through a display panel 1141.

In some examples, the electronic device 1000 may be configured as a smartphone, camera, smart TV, monitor, smartwatch, tablet, automotive display, or AR/VR headset. For example, the electronic device 1000 may be a smartphone including a touch-sensitive display area DA for interaction and a non-display area NDA including sensors and circuits for enhanced functionality. For example, the electronic device 1000 may be a television or monitor including a large display area DA for high-resolution video playback and a non-display area NDA incorporating driving circuits or connectivity modules for external inputs. For example, the electronic device 1000 may be a smartwatch including a display area DA optimized for compact and high-clarity visuals and a non-display area NDA integrating biometric sensors for health monitoring. In some cases, the electronic device 1000 be an AR/VR headset.

In some examples, memory 1120 may store information such as software codes for operating an application program 1123. The application program 1123 may include a software designed to execute specific tasks or provide functionality to a user. The application program 1123 may operate under the control of the processor 1110 and utilizes data stored in the memory 1120 to deliver a wide range of features, such as productivity tools, multimedia streaming and playback, file or mail deliveries or communication services. The application program 1123 interacts seamlessly with the user interface 1161 or touch screen 1142, allowing a user to launch, navigate, and utilize the program through user inputs such as touch, tap, gesture, or voice interaction.

Upon user selection of an application via touch screen 1142 or user interface 1161, the processor 1110 may execute the application program 1123 corresponding to the selected application retrieved from the memory 1120 to perform functionalities of the application. For example, when a user selects a camera application by tapping the icon (or a camera application icon) presented on the display panel 1141, the processor 1110 activates a camera module. The processor 1110 may transmit image data corresponding to a captured image acquired through the camera module to the display module 1140. The display module 1140 may display an image corresponding to the captured image through the display panel 1141.

As another example, when a user wishes to make a phone call, the user taps the telephone icon displayed on the display module 1140, the processor 1110 may execute a phone application program stored in the memory 1120. A telephone keypad may be presented on the display panel 1141 for the user to enter a phone number to call.

As another example, the display module 1140 may be integrated into an electronic device 1000, such as a laptop computer, smart TV, or tablet. A user wishing to access a multimedia streaming application (e.g., to watch a music video or movie) can do so by tapping the corresponding icon. This action activates the application, allowing the user to view the streamed content.

The processor 1110 may include a main processor 1111 and an auxiliary or coprocessor 1112. The main processor 1111 may include a central processing unit (CPU). The main processor 1111 may further include one or more of a graphics processing unit (GPU), a communication processor (CP), and an image signal processor (ISP).

The coprocessor 1112 may include a controller 1112-1. The controller 1112-1 may include an interface conversion circuit and a timing control circuit. The controller 1112-1 may receive an image signal from the main processor 1111, convert the data format of the image signal to match the interface specifications with the display module 1140, and output image data. The controller 1112-1 may output various control signals to drive the display module 1140. For example, the controller 1112-1 may drive the display module 1140 to display the icon on the display screen suitable for selection by a user to cause execution of an application program 1123.

The memory 1120 may store one or more application programs 1123 and various data used by at least one component (for example, the processor 1110 or the user interface 1161) of the electronic device 1000 and input data or output data for commands related thereto. For example, a camera application program, a GPS application program, an augmented reality and virtual reality application program, and other application programs that can be executed by the processor 1110 upon selection of corresponding icons presented on the display screen (or display panel 1141) via the touch screen 1142 or user interface 1161 by the user. In addition, various setting data corresponding to user settings may be stored in the memory 1120. The memory 1120 may include volatile memory 1121 and nonvolatile memory 1122.

The display module 1140 may output visual information (images) to the user. The display module 1140 may include the display panel 1141, a gate driver, the source driver, a voltage generation circuit, and a touch screen 1142. The display module 1140 may further include a window, a chassis, and a bracket to protect the display panel 1141. The display module 1140 may include at least a part of the configuration of the display device shown in FIG. 1.

The user interface 1161 serves as the interaction medium between a user and the electronic device 1000. The user interface 1161 may detect an input by a part (e.g., finger) of a user's body or an input by a pen or a mouse, and generate an electric signal or data value corresponding to the input. The user interface 1161 includes the fingerprint sensor 1162, the input sensor 1163, and a digitizer 1164.

The fingerprint sensor 1162 may sense a fingerprint for biometric recognition of the user and may also measure one or more biological signals such as blood pressure, moisture, or body mass.

The input sensor 1163 may sense user interactions including touch, tap, gesture, motion, spoken command, and eye movement. The input sensor 1163 includes optical sensors for image capture, eye tracking, or motion and gesture detection. Optical sensors may be infrared or semiconductor photodetectors. The input sensor 1163 includes audio and acoustic sensors, which may be MEMS microphones for voice recognition or sound-based interaction. The audio and acoustic sensors can be installed as part of the user interface 1161 or embedded in the display panel 1141.

The digitizer 1164 may generate a data value corresponding to coordinate information of input by a pen or a mouse to control movement of an onscreen cursor. The digitizer 1164 may generate the amount of change in electromagnetic due to the input as the data value. The digitizer may detect an input by a passive pen or transmit and receive data with an active pen or a remote.

At least one of the fingerprint sensor 1162, the input sensor 1163, or the digitizer 1164 may be implemented as a sensor layer formed on the top layer of the display panel 1141 through a continuous process with a process of forming elements (for example, the light emitting element, the transistor, and the like) included in the display panel 1141.

In addition, the user interface 1161 may further include, for example, a gesture sensor, a gyro sensor that senses rotational movements, an acceleration sensor to track translational movement, a grip sensor, a pressure sensor, a proximity sensor, a color sensor, an infrared (IR) emitter and camera sensor for tracking gaze direction and eye movements, a temperature sensor, or a light sensor. For example, the gyro sensor, acceleration sensor, and infrared emitter and camera may be particularly suitable for AR/VR headset functions.

The touch screen 1142 includes touch sensors embedded in semiconductor layers of the display panel 1141 to sense pressure applied to the top layer (screen) of the display panel 1141. The touch sensors can be a capacitive or a resistive type. The touch screen 1142 may serve as the primary interface for the user to select and navigate applications, control, and interact with the electronic device 1000.

The display panel 1141 (or display) may include a liquid crystal display panel, an organic light emitting display panel, or an inorganic light emitting display panel, and the type of the display panel 1141 is not particularly limited. The display panel 1141 may be of a rigid type or a flexible type that can be rolled or folded. The display module 1140 may further include a supporter, bracket, heat dissipation member, and the like that support the display panel 1141. The display panel 1141 may include the display unit shown in FIG. 1.

The power source module 1150 may supply power to the components of the electronic device 1000. The power source module 1150 may include a battery that charges the power source voltage. The battery may include a non-rechargeable primary battery or a rechargeable secondary battery or fuel cell. The power source module 1150 may include a power management integrated circuit (PMIC). The PMIC may supply optimized power source to each of the components described above including the display module 1140.

Each of the embodiments described above can be implemented independently, but it goes without saying that the structure of each embodiment can be applied in combination to other embodiments.

The present disclosure has been described with reference to non-limiting embodiments illustrated in the drawings, but this is only an example. It will be understood by those of ordinary skill in the art that various modifications and equivalents may be made thereto.

Specific executions in the described embodiments are an embodiment, which does not limit the scope of the embodiments in any way. In addition, when there is no specific mention such as "essential," "important," etc., it may not be a necessary component for the application of the present disclosure.

The use of the term "the" and similar demonstratives in the specification of the embodiments is to be construed to cover both the singular and the plural. In addition, when a range is described in the embodiments, it includes the invention to which individual values within the range are applied (unless otherwise indicated herein). This is the same as stating each individual value constituting the above range in the detailed description. Finally, operations constituting methods according to embodiments may be performed in any suitable order unless otherwise indicated herein or otherwise clearly contradicted by context. The embodiments are not necessarily limited by the order of description of operations. The use of any and all examples or specific terms provided in the embodiments is simply intended to describe embodiments in detail, and the scope of the embodiments is not limited thereby. In addition, it will be understood by those of ordinary skill in the art that various modifications, combinations and changes may be made according to design conditions and factors within the scope of the appended claims or equivalents thereof.

In a display apparatus according to embodiments, a first organic insulating layer having a first thickness, a second organic insulating layer having a second thickness, and a third organic insulating layer having a third thickness may be arranged on a first conductive layer, and the sum of the first thickness to the third thickness may be a preset (e.g., a predetermined) thickness. This may result in protecting the first conductive layer by adjusting the position of stress neutral plane (NP) without employing a bending protection layer.

A display apparatus according to an embodiment may adjust the position of stress neutral plane (NP) in a plurality of wires, through organic insulating layers, which have a pattern area and a non-pattern area with different thicknesses in a bending area, thereby reducing strain and simultaneously implementing an optimized structure of the organic insulating layers for applying a tight bending structure.

However, the effects of embodiments of the present disclosure are not limited to the above effects, and may be expanded in various ways.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the invention as defined by the claims.

## Claims

1. A display apparatus comprising:
a substrate having a bending area positioned between a first area and a second area, the substrate being bendable in the bending area along a bending axis;
a conductive layer extending from the first area to the second area through the bending area, and arranged on the substrate;
a first organic insulating layer arranged on the conductive layer;
a second organic insulating layer arranged on the first organic insulating layer; and
a third organic insulating layer arranged on the second organic insulating layer,
wherein the sum of the thicknesses of the first to third organic insulating layers is in a range of about 2 to about 30 times the thickness of the conductive layer.

2. The display apparatus of claim 1, wherein:
the thickness of one of the first to third organic insulating layers is greater than the thickness of one of the other of the first to third organic insulating layers.

3. The display apparatus of claim 2, wherein:
the thickness of the third organic insulating layer is less than or equal to the sum of the thickness of the first organic insulating layer and the thickness of the second organic insulating layer.

4. The display apparatus of claim 3, wherein:
the thickness of the third organic insulating layer is twice the thickness of the first organic insulating layer or the thickness of the second organic insulating layer.

5. The display apparatus of any one of the preceding claims, wherein:
the second organic insulating layer comprises a material that is different from materials of the first organic insulating layer and the third organic insulating layer.

6. The display apparatus of claim 5, wherein:
the thickness of the second organic insulating layer is equal to the thickness of the first organic insulating layer; and
the thickness of the third organic insulating layer is twice the thickness of the first organic insulating layer.

7. The display apparatus of any one of the preceding claims, further comprising:
a fourth organic insulating layer arranged on the third organic insulating layer,
wherein the sum of the thicknesses of the first to fourth organic insulating layers is in a range of about 2 to about 30 times the thickness of the conductive layer.

8. The display apparatus of claim 7, wherein:
the third organic insulating layer comprises a material different from materials of the first organic insulating layer and the second organic insulating layer.

9. The display apparatus of claim 8, wherein:
the thickness of the third organic insulating layer is less than or equal to the thickness of the second organic insulating layer.

10. The display apparatus of claim 7, 8 or 9, further comprising:
a pixel defining layer arranged on the first area, and defining an emission area through an opening; and
a spacer arranged on the pixel defining layer,
wherein the third organic insulating layer comprises the same material as a material of the pixel defining layer.

11. The display apparatus of claim 10, wherein the pixel defining layer comprises a light-shielding material.

12. An electronic apparatus comprising:
a processor;
a memory having stored application programs for execution by the processor;
a display apparatus according to any one of the preceding claims; and
a user interface configured to sense user input via touch or cursor select of an icon presented on the display apparatus, wherein the processor is caused to execute one or more of the stored application programs upon receipt of the user input.
